(19) **Europäisches Patentamt / European Patent Office / Office européen des brevets**

(11) **EP 4 350 240 A1**

(12) # EUROPEAN PATENT APPLICATION
published in accordance with Art. 153(4) EPC

(43) Date of publication:
**10.04.2024 Bulletin 2024/15**

(21) Application number: **22849016.5**

(22) Date of filing: **30.05.2022**

(51) International Patent Classification (IPC):
**F24F 11/65** (2018.01)  **F24F 110/10** (2018.01)

(52) Cooperative Patent Classification (CPC):
**F24F 11/65;** F24F 2110/10

(86) International application number:
**PCT/JP2022/021873**

(87) International publication number:
**WO 2023/007937 (02.02.2023 Gazette 2023/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.07.2021 JP 2021125605**

(71) Applicant: **MITSUBISHI ELECTRIC
CORPORATION
Chiyoda-ku
Tokyo 100-8310 (JP)**

(72) Inventors:
  • **HOKARI, Hiroaki
    Tokyo 100-8310 (JP)**

  • **NAKANE, Koki
    Tokyo 100-8310 (JP)**
  • **MARIYAMA, Toshisada
    Tokyo 100-8310 (JP)**
  • **MIYAZAKI, Naoyuki
    Tokyo 108-0023 (JP)**
  • **HASEGAWA, Osamu
    Tokyo 108-0023 (JP)**
  • **BABA, Wataru
    Tokyo 108-0023 (JP)**

(74) Representative: **Pfenning, Meinig & Partner mbB
Patent- und Rechtsanwälte
Joachimsthaler Straße 10-12
10719 Berlin (DE)**

(54) **AIR CONDITIONING CONTROL DEVICE AND AIR CONDITIONING CONTROL METHOD**

(57)    An air control device (3) includes: an operation pattern acquiring unit (11) to acquire operation patterns indicating an operation target air conditioner (1-k) in a room; a temperature data acquiring unit (12) to acquire temperature data indicating a temperature measured by a temperature sensor (2-1 to 2-M) when the air conditioner (1-k) is in operation; a prediction model generating unit (13) to generate, using a control amount of the air conditioner (1-k) and temperature data acquired when the air conditioner (1-k) is in operation as training data, a room-temperature prediction model for predicting the temperature measured by the temperature sensor (2-1 to 2-M) when the air conditioner (1-k) are in operation; and an operation pattern selecting unit (14) to provide the control amount of the air conditioner (1-k) to the room-temperature prediction model to acquire a prediction temperature from each of the room-temperature prediction models, and selects one operation pattern from the operation patterns on the basis of the prediction temperature.

# FIG. 1

Server Rack

Data Center

2-2

1-6

1-5

1-4

1-3

1-2

1-1

1-12

1-11

1-10

1-9

1-8

1-7

2-1

3

Air Conditioning Control Device

G Operation Patterns

| 11 | Operation Pattern Acquiring Unit |
| --- | --- |

| 12 | Temperature Data Acquiring Unit |
| --- | --- |

| 15 | Air Conditioner Control Unit |
| --- | --- |

| 13 | Prediction Model Generating Unit |
| --- | --- |

| 14 | Operation Pattern Selecting Unit |
| --- | --- |

## Description

### TECHNICAL FIELD

The present disclosure relates to an air conditioning control device and an air conditioning control method.

### BACKGROUND ART

A plurality of electronic devices is installed in a data center, a server room, or the like. The electronic devices include computers, communication devices, or the like. A plurality of air conditioners is installed in the data center or the like in order to suppress an increase in indoor temperature due to heat generated from the electronic devices. When some air conditioners among the plurality of air conditioners installed in the data center or the like are operated, the temperature of the data center or the like may be maintained at a certain temperature or lower. In order to suppress the power consumption of the air conditioners, it is desirable that the number of air conditioners to be actually operated is small. An air conditioner that is not actually operated is used as a backup machine.

Some air conditioning control devices that control a plurality of air conditioners installed in a server room can determine one or more air conditioners to be actually operated among the plurality of air conditioners (hereinafter referred to as "conventional air conditioning control device", see Patent Literature 1). The conventional air conditioning control device acquires layout data indicating a position of a hot aisle that is a path through which high-temperature air discharged from electronic devices passes and positions of a plurality of air conditioners. Then, the conventional air conditioning control device determines one or more air conditioners to be actually operated among the plurality of air conditioners on the basis of the layout data.

### CITATION LIST

### PATENT LITERATURES

Patent Literature 1: JP 2018-005646 A

### SUMMARY OF INVENTION

### TECHNICAL PROBLEM

The conventional air conditioning control device has a problem that, if the layout data cannot be acquired, it is impossible to determine one or more air conditioners to be actually operated among the plurality of air conditioners installed in the server room.

The present disclosure has been made to solve the above problem, and an object thereof is to obtain an air conditioning control device and an air conditioning control method with which it is possible to determine one or more air conditioners to be actually operated among a plurality of air conditioners without acquiring layout data.

### SOLUTION TO PROBLEM

An air conditioning control device according to the present disclosure includes: an operation pattern acquiring unit to acquire a plurality of operation patterns each indicating at least one operation target air conditioner among a plurality of air conditioners installed in a room; a temperature data acquiring unit to acquire temperature data indicating a measurement temperature of a temperature sensor installed in the room when the at least one operation target air conditioner indicated by each of the plurality of operation patterns is in operation; a prediction model generating unit to generate, using a control amount of the at least one operation target air conditioner indicated by each of the plurality of operation patterns and the temperature data acquired by the temperature data acquiring unit when the at least one operation target air conditioner is in operation as training data, a room-temperature prediction model, which corresponds to each of the plurality of operation patterns, for predicting a temperature measured by the temperature sensor when the at least one operation target air conditioner indicated by each of the plurality of operation patterns is in operation; and an operation pattern selecting unit to acquire a prediction temperature from the room-temperature prediction model by providing the control amount of the at least one operation target air conditioner indicated by each of the plurality of operation patterns to the room-temperature prediction model generated by the prediction model generating unit, and selects one operation pattern from the plurality of operation patterns on a basis of the prediction temperature.

## ADVANTAGEOUS EFFECTS OF INVENTION

According to the present disclosure, it is possible to determine one or more air conditioners to be actually operated among a plurality of air conditioners without acquiring layout data.

## BRIEF DESCRIPTION OF DRAWINGS

FIG. 1 is a configuration diagram illustrating an air conditioning system including an air conditioning control device 3 according to a first embodiment.
FIG. 2 is a hardware configuration diagram illustrating hardware of the air conditioning control device 3 according to the first embodiment.
FIG. 3 is a hardware configuration diagram of a computer in a case where the air conditioning control device 3 is implemented by software, firmware, or the like.
FIG. 4 is a flowchart illustrating an air conditioning control method which is a processing procedure performed by the air conditioning control device 3.
FIG. 5 is a flowchart illustrating a part of the processing procedure performed by the air conditioning control device 3.
FIG. 6 is a configuration diagram illustrating an air conditioning system including an air conditioning control device 3 according to a second embodiment.
FIG. 7 is a hardware configuration diagram illustrating hardware of the air conditioning control device 3 according to the second embodiment.
FIG. 8 is an explanatory diagram illustrating candidates for a set temperature $PT_k$ determined by a set temperature determining unit 18.
FIG. 9 is an explanatory diagram illustrating accuracy of a room-temperature prediction model $RTM_g$ with respect to a set temperature $PT_k$.

## DESCRIPTION OF EMBODIMENTS

In order to describe the present disclosure in more detail, some modes for carrying out the present disclosure will now be described with reference to the accompanying drawings.

First Embodiment

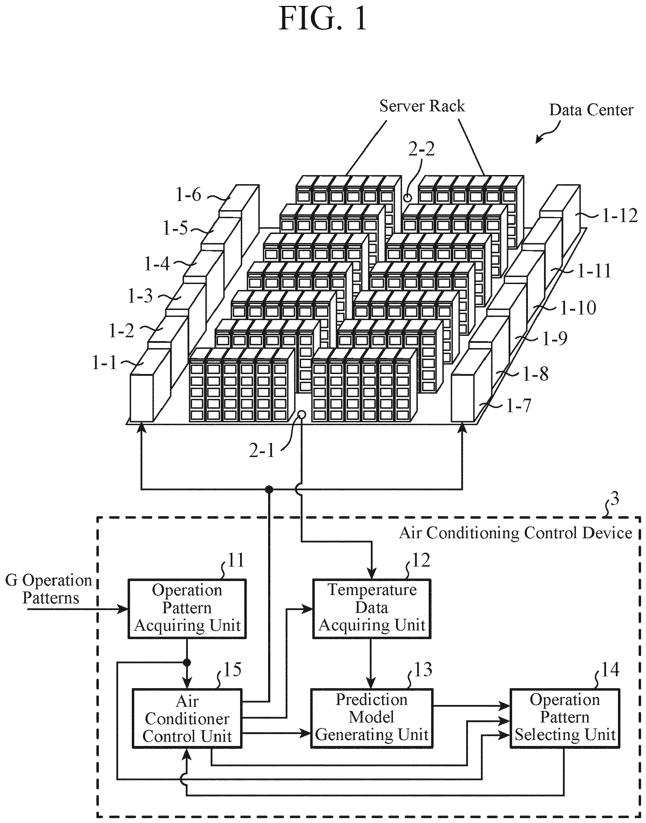

FIG. 1 is a configuration diagram illustrating an air conditioning system including an air conditioning control device 3 according to a first embodiment.

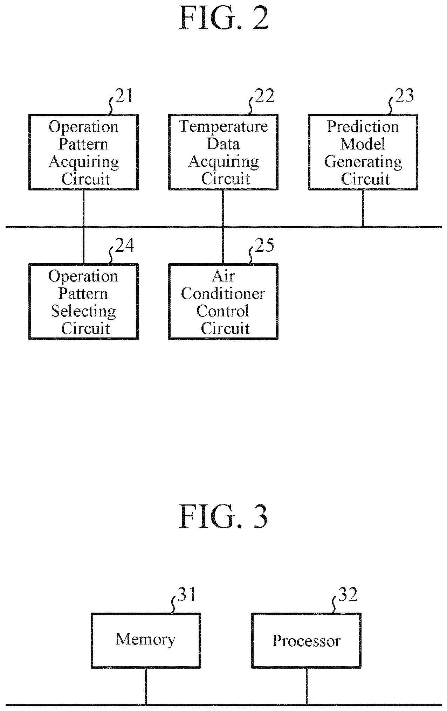

FIG. 2 is a hardware configuration diagram illustrating hardware of the air conditioning control device 3 according to the first embodiment.
The air conditioning system illustrated in FIG. 1 is a system that manages a temperature in a room in which electronic devices are installed. The electronic devices include computers, communication devices, or the like. Examples of the room managed by the air conditioning system include a data center and a server room.
The air conditioning system illustrated in FIG. 1 includes N air conditioners 1-1 to 1-N, M temperature sensors 2-1 to 2-M, and the air conditioning control device 3. Each of N and M is an integer equal to or greater than 2.
A plurality of server racks is disposed in a data center or the like, and each of the server racks houses a plurality of electronic devices. In the example of FIG. 1, 14 server racks are disposed.
The air conditioners 1-1 to 1-N are installed in the data center or the like. In the example of FIG. 1, N = 12.
The temperature sensors 2-1 to 2-M are installed in the data center or the like. FIG. 1 illustrates an example in which M = 2 for simplification of the drawing. In practice, temperature sensors 2-m (m = 1, ..., M) are installed at intervals of several meters. In addition, the temperature sensors 2-m are installed, for example, at a position 1.5 m above and at a position 2.5 m above the floor of the data center or the like.
Each of the temperature sensors 2-m (m = 1, ..., M) measures a temperature at a position where the temperature sensor is installed in the data center or the like, and outputs temperature data indicating a measurement temperature $MT_m$ to the air conditioning control device 3.
The air conditioning control device 3 includes an operation pattern acquiring unit 11, a temperature data acquiring unit 12, a prediction model generating unit 13, an operation pattern selecting unit 14, and an air conditioner control unit 15.
The operation pattern acquiring unit 11 is implemented by, for example, an operation pattern acquiring circuit 21 illustrated in FIG. 2.
The operation pattern acquiring unit 11 acquires G operation patterns $OP_1$ to $OP_G$ each indicating operation target air conditioners 1-k among the N air conditioners 1-1 to 1-N.

The number G of the operation patterns OP acquired by the operation pattern acquiring unit 11 is, for example, the number of combinations $_NC_P$ of selecting P or more air conditioners 1 from N air conditioners 1-1 to 1-N, and P is an integer not less than 1 but less than N.

When the operation target air conditioners are, for example, the air conditioners 1-3, 1-5, 1-8, and 1-10, k = 3, 5, 8, and 10. When the operation target air conditioners are, for example, the air conditioners 1-4, 1-7, and 1-9, k = 4, 7, and 9.

The operation pattern acquiring unit 11 outputs the G operation patterns $OP_1$ to $OP_G$ to each of the operation pattern selecting unit 14 and the air conditioner control unit 15.

In the air conditioning system illustrated in FIG. 1, the operation pattern acquiring unit 11 acquires the operation pattern $OP_g$ (g = 1, ..., G) from the outside of the air conditioning control device 3. However, this is merely an example, and the operation pattern acquiring unit 11 may acquire the operation pattern $OP_g$ from, for example, a storage device (not illustrated) of the air conditioning control device 3.

The temperature data acquiring unit 12 is implemented by, for example, a temperature data acquiring circuit 22 illustrated in FIG. 2.

The temperature data acquiring unit 12 acquires temperature data indicating a measurement temperature $MT_m$ which is a temperature measured by the temperature sensor 2-m (m = 1, ..., M) when the operation target air conditioner 1-k indicated by each operation pattern $OP_g$ is in operation.

The temperature data acquiring unit 12 outputs the acquired temperature data indicating the measurement temperature $MT_m$ to the prediction model generating unit 13.

The prediction model generating unit 13 is implemented by, for example, a prediction model generating circuit 23 illustrated in FIG. 2.

The prediction model generating unit 13 acquires the temperature data indicating the measurement temperature $MT_m$ from the temperature data acquiring unit 12, and acquires a control amount of the operation target air conditioner 1-k indicated by the operation pattern $OP_g$ from the air conditioner control unit 15.

As the control amount of the operation target air conditioner 1-k, for example, the set temperature of the air conditioner 1-k, the air volume of the air conditioner 1-k, or the frequency of the operating voltage of a compressor connected to the air conditioner 1-k is conceivable. In the following description, the control amount of the air conditioner 1-k is the set temperature of the air conditioner 1-k in the air conditioning system illustrated in FIG. 1.

The prediction model generating unit 13 uses, as training data, the set temperature $PT_k$ of the operation target air conditioner 1-k indicated by the operation pattern $OP_g$ (g = 1, ..., G) and the temperature data acquired by the temperature data acquiring unit 12 when the operation target air conditioner is operating, to generate a room-temperature prediction model $RTM_g$ for predicting the temperature to be measured by the temperature sensor 2-m (m = 1, ..., M) when the operation target air conditioner 1-k indicated by the operation pattern $OP_g$ is operating.

The prediction model generating unit 13 outputs the generated G room-temperature prediction models $RTM_1$ to $RTM_G$ to the operation pattern selecting unit 14.

The operation pattern selecting unit 14 is implemented by, for example, an operation pattern selecting circuit 24 illustrated in FIG. 2.

The operation pattern selecting unit 14 acquires the G operation patterns $OP_1$ to $OP_G$ from the operation pattern acquiring unit 11, and acquires the G room-temperature prediction models $RTM_1$ to $RTM_G$ from the prediction model generating unit 13.

In addition, the operation pattern selecting unit 14 acquires the set temperature $PT_k$ of the operation target air conditioner 1-k indicated by the operation pattern $OP_g$ from the air conditioner control unit 15.

The operation pattern selecting unit 14 provides the set temperature $PT_k$ that is the control amount of the operation target air conditioner 1-k indicated by the operation pattern $OP_g$ to the room-temperature prediction model $RTM_g$ (g = 1, ..., G) to acquire a prediction temperature $FT_g$ from the room-temperature prediction model $RTM_g$.

The operation pattern selecting unit 14 selects one operation pattern $OP_{SEL}$ from among the G operation patterns $OP_1$ to $OP_G$ on the basis of the prediction temperature $FT_g$ (g = 1, ..., G).

The operation pattern selecting unit 14 outputs the selected one operation pattern $OP_{SEL}$ to the air conditioner control unit 15.

The air conditioner control unit 15 is implemented by, for example, an air conditioner control circuit 25 illustrated in FIG. 2.

The air conditioner control unit 15 acquires the G operation patterns $OP_1$ to $OP_G$ from the operation pattern acquiring unit 11.

The air conditioner control unit 15 operates the operation target air conditioner 1-k indicated by the operation pattern $OP_g$ at the set temperature $PT_k$ in order to cause the prediction model generating unit 13 to generate the G room-temperature prediction models $RTM_1$ to $RTM_G$. For example, suppose G = 3. In this case, the air conditioner control unit 15 repeatedly performs an operation of the operation target air conditioner 1-k indicated by the operation

pattern $OP_1$ at the set temperature $PT_k$ for a certain period of time, and then, after the indoor temperature returns to the temperature before the activation of the operation target air conditioner 1-k, operating again the operation target air conditioner 1-k indicated by the operation pattern $OP_1$ at the set temperature $PT_k$ for a certain period of time.

Thereafter, the air conditioner control unit 15 repeatedly performs an operation of the operation target air conditioner 1-k indicated by the operation pattern $OP_2$ at the set temperature $PT_k$ for a certain period of time, and then, after the indoor temperature returns to the temperature before the activation of the operation target air conditioner 1-k, performs again an operation of the operation target air conditioner 1-k indicated by the operation pattern $OP_2$ at the set temperature $PT_k$ for a certain period of time.

Thereafter, the air conditioner control unit 15 repeatedly performs an operation of the operation target air conditioner 1-k indicated by the operation pattern $OP_3$ at the set temperature $PT_k$ for a certain period of time, and then, after the indoor temperature returns to the temperature before the activation of the operation target air conditioner 1-k, performs again an operation of the operation target air conditioner 1-k indicated by the operation pattern $OP_3$ at the set temperature $PT_k$ for a certain period of time.

When operating the operation target air conditioner 1-k at the set temperature $PT_k$, the air conditioner control unit 15 outputs the set temperature $PT_k$ of the air conditioner 1-k to each of the prediction model generating unit 13 and the operation pattern selecting unit 14.

The set temperature $PT_k$ of the operation target air conditioner 1-k may be stored in an internal memory of the air conditioner control unit 15 or may be given from the outside of the air conditioning control device 3.

The air conditioner control unit 15 operates the operation target air conditioner 1-k indicated by the operation pattern $OP_{SEL}$ selected by the operation pattern selecting unit 14 at the set temperature $PT_k$.

FIG. 1 illustrates an example in which each of the operation pattern acquiring unit 11, the temperature data acquiring unit 12, the prediction model generating unit 13, the operation pattern selecting unit 14, and the air conditioner control unit 15, which are components of the air conditioning control device 3, is implemented by dedicated hardware as illustrated in FIG. 2. That is, it is assumed that the air conditioning control device 3 is implemented by the operation pattern acquiring circuit 21, the temperature data acquiring circuit 22, the prediction model generating circuit 23, the operation pattern selecting circuit 24, and the air conditioner control circuit 25.

Here, each of the operation pattern acquiring circuit 21, the temperature data acquiring circuit 22, the prediction model generating circuit 23, the operation pattern selecting circuit 24, and the air conditioner control circuit 25 is, for example, a single circuit, a composite circuit, a programmed processor, a parallel programmed processor, an application specific integrated circuit (ASIC), a field-programmable gate array (FPGA), or a combination of some of these circuits.

The components of the air conditioning control device 3 are not limited to be implemented by dedicated hardware, and the air conditioning control device 3 may be implemented by software, firmware, or a combination of software and firmware.

Software or firmware is stored in a memory of a computer as a program. The computer means hardware that executes the program, and may be, for example, a central processing unit (CPU), a central processor, a processing unit, a computing unit, a microprocessor, a microcomputer, a processor, or a digital signal processor (DSP).

FIG. 3 is a hardware configuration diagram of a computer in a case where the air conditioning control device 3 is implemented by software, firmware, or the like.

In a case where the air conditioning control device 3 is implemented by software, firmware, or the like, a program for causing the computer to execute the processing procedures performed in the operation pattern acquiring unit 11, the temperature data acquiring unit 12, the prediction model generating unit 13, the operation pattern selecting unit 14, and the air conditioner control unit 15 is stored in a memory 31. Then, a processor 32 of the computer executes the program stored in the memory 31.

Further, FIG. 2 shows an example in which each of the components of the air conditioning control device 3 is implemented by dedicated hardware, and FIG. 3 shows an example in which the air conditioning control device 3 is implemented by software, firmware, or the like. However, this is merely an example, and some components in the air conditioning control device 3 may be implemented by dedicated hardware, and the remaining components may be implemented by software, firmware, or the like.

Next, the operation of the air conditioning system illustrated in FIG. 1 will be described.

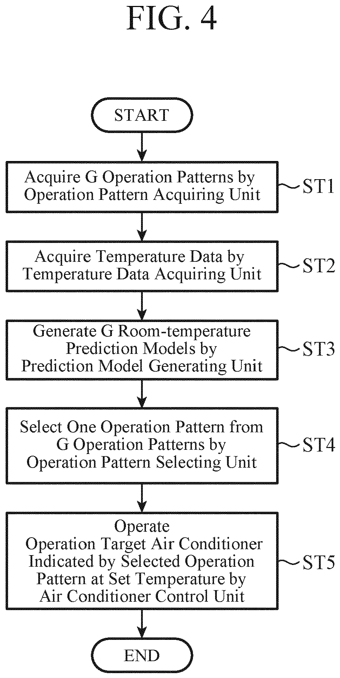

FIG. 4 is a flowchart illustrating an air conditioning control method which is a processing procedure performed by the air conditioning control device 3.

The operation pattern acquiring unit 11 acquires G operation patterns $OP_1$ to $OP_G$ indicating the operation target air conditioners 1-k from outside the air conditioning control device 3 (step ST1 in FIG. 4).

The operation pattern acquiring unit 11 outputs the G operation patterns $OP_1$ to $OP_G$ to each of the operation pattern selecting unit 14 and the air conditioner control unit 15.

The air conditioner control unit 15 acquires the G operation patterns $OP_1$ to $OP_G$ from the operation pattern acquiring unit 11.

The air conditioner control unit 15 operates the operation target air conditioner 1-k indicated by each operation pattern $OP_g$ at the set temperature $PT_k$ in order to cause the prediction model generating unit 13 to generate the G room-temperature prediction models $RTM_1$ to $RTM_G$.

For example, suppose that G = 2, the operation target air conditioner 1-k indicated by the operation pattern $OP_1$ is the air conditioners 1-3 and 1-8, and the operation target air conditioner 1-k indicated by the operation pattern $OP_2$ is the air conditioners 1-5 and 1-10. Further, suppose that the set temperatures $PT_k$ of all the operation target air conditioners 1-k are 19 degrees, and the temperature of the room in which the electronic devices such as a computer are installed is 25 degrees.

In this case, the air conditioner control unit 15 operates the operation target air conditioners 1-3 and 1-8 indicated by the operation pattern $OP_1$ at the set temperature $PT_k$ (= 19 degrees) for a certain period of time. The certain period of time is, for example, 1 hour or 1.5 hours.

The air conditioner control unit 15 operates the operation target air conditioners 1-3 and 1-8 at the set temperature $PT_k$ for a certain period of time, and then, after the indoor temperature returns to 25 degrees which is the temperature before the air conditioners 1-3 and 1-8 are operated, operates the operation target air conditioners 1-3 and 1-8 indicated by the operation pattern $OP_1$ at the set temperature $PT_k$ (= 19 degrees) for a certain period of time.

The air conditioner control unit 15 operates the operation target air conditioners 1-3 and 1-8 indicated by the operation pattern $OP_1$ Q times, for example. Q is an integer equal to or greater than 2.

Thereafter, when the indoor temperature returns to 25 degrees which is the temperature before the air conditioners 1-3 and 1-8 are operated, the air conditioner control unit 15 operates the operation target air conditioners 1-5 and 1-10 indicated by the operation pattern $OP_2$ at the set temperature $PT_k$ (= 19 degrees) for a certain period of time.

When the indoor temperature returns to 25 degrees which is the temperature before the air conditioners 1-5 and 1-10 are operated after the operation target air conditioners 1-5 and 1-10 are operated, the air conditioner control unit 15 operates the operation target air conditioners 1-5 and 1-10 indicated by the operation pattern $OP_2$ at the set temperature $PT_k$ (= 19 degrees) for a certain period of time.

The air conditioner control unit 15 operates the operation target air conditioners 1-5 and 1-10 indicated by the operation pattern $OP_2$ Q times, for example.

When operating the operation target air conditioner 1-k at the set temperature $PT_k$, the air conditioner control unit 15 outputs the set temperature $PT_k$ of the air conditioner 1-k to each of the prediction model generating unit 13 and the operation pattern selecting unit 14. In addition, the air conditioner control unit 15 outputs a request to generate the room-temperature prediction model $RTM_g$ corresponding to each operation pattern $OP_g$ to the prediction model generating unit 13.

The air conditioner control unit 15 outputs, to the temperature data acquiring unit 12, a data acquisition request to instruct acquisition of temperature data for a certain period of time after the operation target air conditioner 1-k starts operation.

When receiving the data acquisition request from the air conditioner control unit 15, the temperature data acquiring unit 12 acquires temperature data indicating the measurement temperature $MT_m$ of the temperature sensor 2-m (m = 1, ..., M) (step ST2 in FIG. 4).

For example, when G = 2 and the air conditioner control unit 15 has operated the operation target air conditioners 1-3 and 1-8 indicated by the operation pattern $OP_1$ Q times at the set temperature $PT_k$, the temperature data acquiring unit 12 acquires temperature data indicating the measurement temperature $MT_m$ which is the temperature measured by the temperature sensor 2-m during operation of each of the air conditioners 1-3 and 1-8. Therefore, the temperature data acquiring unit 12 acquires Q pieces of temperature data when the operation target air conditioners 1-3 and 1-8 indicated by the operation pattern $OP_1$ are operated.

In addition, when the air conditioner control unit 15 has operated the operation target air conditioners 1-5 and 1-10 indicated by the operation pattern $OP_2$ Q times at the set temperature $PT_k$, the temperature data acquiring unit 12 acquires temperature data indicating the measurement temperature $MT_m$ which is the temperature measured by the temperature sensor 2-m during operation of each of the air conditioners 1-5 and 1-10. Therefore, the temperature data acquiring unit 12 acquires Q pieces of temperature data when the operation target air conditioners 1-5 and 1-10 indicated by the operation pattern $OP_2$ are operated.

The temperature data acquiring unit 12 outputs the acquired G x Q pieces of temperature data indicating the measurement temperature $MT_m$ to the prediction model generating unit 13.

The prediction model generating unit 13 acquires G x Q pieces of temperature data from the temperature data acquiring unit 12.

The prediction model generating unit 13 acquires, from the air conditioner control unit 15, the set temperature $PT_k$ of the operation target air conditioner 1-k indicated by the operation pattern $OP_g$ (g = 1, ..., G) and the request to generate the room-temperature prediction model $RTM_g$ corresponding to the operation pattern $OP_g$.

When acquiring the request to generate the room-temperature prediction model $RTM_g$, the prediction model generating unit 13 prepares a data set including the set temperature $PT_k$ of the operation target air conditioner 1-k indicated by the operation pattern $OP_g$ and the qth (q = 1, ..., Q) temperature data among the Q pieces of temperature data as Q pieces of training data to be provided to each room-temperature prediction model $RTM_g$.

$$\text{First data set = set temperature } PT_k \text{ of air conditioner 1-k + first temperature data}$$

$$\text{Second data set = set temperature } PT_k \text{ of air conditioner 1-k + second temperature data}$$

$$:$$

$$\text{Qth data set = set temperature } PT_k \text{ of air conditioner 1-k + Qth temperature data}$$

The prediction model generating unit 13 provides the first data set to the untrained room-temperature prediction model $RTM_g$, and performs training to change the internal parameter of the room-temperature prediction model $RTM_g$ in such a way that a prediction temperature $FT_g$ output from the room-temperature prediction model $RTM_g$ approaches the measurement temperature $MT_m$ indicated by the first temperature data.

Next, the prediction model generating unit 13 provides the second data set to the room-temperature prediction model $RTM_g$ which has been trained by the first data set, and performs training to change the internal parameter of the room-temperature prediction model $RTM_g$ in such a way that the prediction temperature $FT_g$ output from the room-temperature prediction model $RTM_g$ approaches the measurement temperature $MT_m$ indicated by the second temperature data.

Thereafter, the prediction model generating unit 13 provides the qth (q = 3, ..., Q) data set to the room-temperature prediction model $RTM_g$ which has been trained by the (q-1)th data set, and performs training to change the internal parameter of the room-temperature prediction model $RTM_g$ in such a way that the prediction temperature $FT_g$ output from the room-temperature prediction model $RTM_g$ approaches the measurement temperature $MT_m$ indicated by the qth temperature data.

As described above, the prediction model generating unit 13 generates the room-temperature prediction model $RTM_g$ (g = 1, ..., G) corresponding to each of the G operation patterns $OP_1$ to $OP_G$ (step ST3 in FIG. 4).

The room-temperature prediction model $RTM_g$ may be any machine learning model that can output the prediction temperature $FT_g$ of the temperature measured by the temperature sensor 2-m after a certain period of time when receiving the set temperature $PT_k$ of the operation target air conditioner 1-k, and may be of any type of prediction model. Examples of the room-temperature prediction model $RTM_g$ include a linear regression model, a gradient boosting tree, and a neural network.

A process for generating the room-temperature prediction model $RTM_g$ is a known technique, and thus, the detailed description thereof will be omitted.

The prediction model generating unit 13 outputs the generated G room-temperature prediction models $RTM_1$ to $RTM_G$ to the operation pattern selecting unit 14.

Here, the prediction model generating unit 13 generates the room-temperature prediction model $RTM_g$ using Q data sets as training data. However, this is merely an example. The prediction model generating unit 13 may prepare Q data sets each including the power consumption and the like of all the electronic devices installed in the data center and the like, and may generate the room-temperature prediction model $RTM_g$ using Q data sets including the power consumption and the like of the electronic devices as the training data.

The operation pattern selecting unit 14 acquires the G operation patterns $OP_1$ to $OP_G$ from the operation pattern acquiring unit 11, and acquires the G room-temperature prediction models $RTM_1$ to $RTM_G$ from the prediction model generating unit 13.

In addition, the operation pattern selecting unit 14 acquires the set temperature $PT_k$ of the operation target air conditioner 1-k indicated by the operation pattern $OP_g$ from the air conditioner control unit 15.

The operation pattern selecting unit 14 gives the set temperature $PT_k$ to each of the G room-temperature prediction models $RTM_1$ to $RTM_G$, and acquires the prediction temperature $FT_g$ from the room-temperature prediction model $RTM_g$ (g = 1, ..., G).

The operation pattern selecting unit 14 selects one operation pattern $OP_{SEL}$ from among the G operation patterns $OP_1$ to $OP_G$ on the basis of the prediction temperature $FT_g$ (g = 1, ..., G) (step ST4 in FIG. 4).

The operation pattern selecting unit 14 outputs the selected one operation pattern $OP_{SEL}$ to the air conditioner control unit 15.

For example, the operation pattern selecting unit 14 tentatively selects, from among the G operation patterns $OP_1$ to $OP_G$, an operation pattern in which the prediction temperature $FT_g$ obtained from the corresponding room-temperature prediction model $RTM_g$ (g = 1, ..., G) is equal to or less than a temperature upper limit value $T_{max}$, and the prediction accuracy of the corresponding room-temperature prediction model $RTM_g$ is within a threshold. The temperature upper limit value $T_{max}$ is the highest possible indoor temperature that does not affect the electronic device, and is several degrees higher than the set temperature $PT_k$. The temperature upper limit value $T_{max}$ may be stored in the internal memory of the operation pattern selecting unit 14 or may be given from the outside of air conditioning control device 3.

The prediction accuracy of the room-temperature prediction model $RTM_g$ is output from the room-temperature prediction model $RTM_g$. The threshold may be 1.5 degrees, 2 degrees, or the like. Therefore, when the threshold is, for example, 1.5 degrees, the room-temperature prediction model $RTM_g$ whose prediction accuracy is within 1.5 degrees is selected. The threshold may be stored in the internal memory of the operation pattern selecting unit 14 or may be given from the outside of the air conditioning control device 3.

The operation pattern selecting unit 14 selects one operation pattern in which the number of operation target air conditioners 1-k is relatively small from among one or more operation patterns tentatively selected. That is, the operation pattern selecting unit 14 selects the operation pattern in which the number of operation target air conditioners 1-k is the smallest as the operation pattern $OP_{SEL}$ from among the one or more operation patterns tentatively selected.

The air conditioner control unit 15 acquires the operation pattern $OP_{SEL}$ from the operation pattern selecting unit 14.

The air conditioner control unit 15 operates the operation target air conditioner 1-k indicated by the operation pattern $OP_{SEL}$ at the set temperature $PT_k$ (step ST5 in FIG. 4).

In the first embodiment described above, the air conditioning control device 3 includes: the operation pattern acquiring unit 11 to acquire a plurality of operation patterns indicating an operation target air conditioner 1-k among a plurality of air conditioners 1-1 to 1-N installed in a room; and the temperature data acquiring unit 12 to acquire temperature data indicating measurement temperatures of the temperature sensors 2-1 to 2-M installed in the room when the operation target air conditioner 1-k indicated by each of the operation patterns is in operation. The air conditioning control device 3 also includes the prediction model generating unit 13 to generate, using a control amount of the operation target air conditioner 1-k indicated by each of the operation patterns and temperature data acquired by the temperature data acquiring unit 12 when the operation target air conditioner 1-k is in operation as training data, a room-temperature prediction model for predicting the temperatures measured by the temperature sensors 2-1 to 2-M when the operation target air conditioner 1-k indicated by each of the operation patterns is in operation. The air conditioning control device 3 further includes the operation pattern selecting unit 14 to provide the control amount of the operation target air conditioner 1-k indicated by each of the operation patterns to room-temperature prediction models corresponding to the respective operation patterns, generated by the prediction model generating unit 13, acquire a prediction temperature from each of the room-temperature prediction models, and selects one operation pattern from the plurality of operation patterns on the basis of the prediction temperature. Accordingly, the air conditioning control device 3 can determine the air conditioner 1-k to be actually operated among the plurality of air conditioners 1-1 to 1-N without acquiring layout data.

In the air conditioning control device 3 illustrated in FIG. 1, the prediction model generating unit 13 generates the G room-temperature prediction models $RTM_1$ to $RTM_G$, and then, the operation pattern selecting unit 14 selects one operation pattern $OP_{SEL}$ from the operation patterns $OP_g$ corresponding to the respective G room-temperature prediction models $RTM_1$ to $RTM_G$.

However, this is merely an example, and the operation pattern selecting unit 14 may select one operation pattern $OP_{SEL}$ as follows.

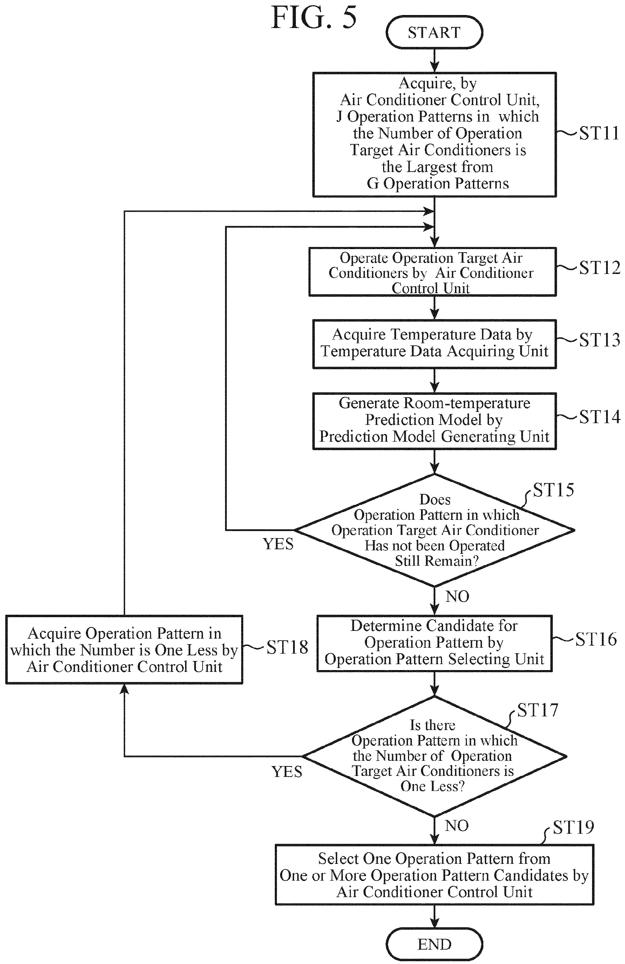

FIG. 5 is a flowchart illustrating a part of the processing procedure performed by the air conditioning control device 3.

First, the air conditioner control unit 15 acquires J operation patterns $OP_j$ (j = 1, ..., J) having the largest number of operation target air conditioners 1-k from among the G operation patterns $OP_1$ to $OP_G$ (step ST11 in FIG. 5). $J \leq G$ is established. For example, in a case where the largest number is (N-3), and there are J operation patterns $OP_j$ having (N-3) operation target air conditioners 1-k, the air conditioner control unit 15 acquires J operation patterns $OP_j$. J is an integer equal to or greater than 1 and equal to or less than G. The operation pattern $OP_g$ and the operation pattern $OP_j$ are basically different from each other.

The air conditioner control unit 15 operates the operation target air conditioner 1-k indicated by the operation pattern $OP_j$ out of the J operation patterns $OP_1$ to $OP_J$ at the set temperature $PT_k$ for a certain period of time (step ST12 in FIG. 5). The air conditioner control unit 15 operates the operation target air conditioner 1-k indicated by the operation pattern $OP_j$ Q times, for example.

When operating the operation target air conditioner 1-k at the set temperature $PT_k$, the air conditioner control unit 15 outputs the set temperature $PT_k$ of the air conditioner 1-k to each of the prediction model generating unit 13 and the operation pattern selecting unit 14. In addition, the air conditioner control unit 15 outputs a request to generate a room-temperature prediction model $RTM_j$ corresponding to the operation pattern $OP_j$ to the prediction model generating unit 13.

When operating the operation target air conditioner 1-k, the air conditioner control unit 15 outputs a data acquisition request to the temperature data acquiring unit 12.

When receiving the data acquisition request from the air conditioner control unit 15, the temperature data acquiring unit 12 acquires Q pieces of temperature data indicating the measurement temperature $MT_m$ of the temperature

sensor 2-m (m = 1, ..., M) (step ST13 in FIG. 5).

The temperature data acquiring unit 12 outputs the acquired Q pieces of temperature data to the prediction model generating unit 13.

The prediction model generating unit 13 acquires, from the temperature data acquiring unit 12, Q pieces of temperature data when the operation target air conditioner 1-k indicated by the operation pattern $OP_j$ is operated at the set temperature $PT_k$.

The prediction model generating unit 13 acquires, from the air conditioner control unit 15, the set temperature $PT_k$ of the operation target air conditioner 1-k indicated by the operation pattern $OP_j$ and a request to generate the room-temperature prediction model $RTM_j$ corresponding to the operation pattern $OP_j$.

When acquiring the request to generate the room-temperature prediction model $RTM_j$, the prediction model generating unit 13 prepares the above-described Q data sets from the Q pieces of temperature data and the set temperature $PT_k$.

The prediction model generating unit 13 sequentially provides the data sets to the room-temperature prediction model $RTM_j$, and repeatedly performs training to change the internal parameter of the room-temperature prediction model $RTM_j$ in such a way that a prediction temperature $FT_j$ output from the room-temperature prediction model $RTM_j$ approaches the measurement temperature $MT_m$ indicated by the temperature data.

Here, the prediction model generating unit 13 provides Q data sets to the room-temperature prediction model $RTM_j$. However, this is merely an example, and the prediction model generating unit 13 may not provide all the data sets to the room-temperature prediction model $RTM_j$ when the prediction accuracy of the room-temperature prediction model $RTM_j$ reaches or is beyond the threshold before providing the Q data sets to the room-temperature prediction model $RTM_j$.

The prediction model generating unit 13 continues the machine learning of the room-temperature prediction model $RTM_j$ by repeatedly providing the data sets to the room-temperature prediction model $RTM_j$, to thereby generate the room-temperature prediction model $RTM_j$ having the prediction accuracy equal to or higher than the threshold (step ST14 in FIG. 5).

The prediction model generating unit 13 outputs the room-temperature prediction model $RTM_j$ having the prediction accuracy equal to or higher than the threshold to the operation pattern selecting unit 14.

If an operation pattern $OP_j$ in which the operation target air conditioner 1-k has not yet been operated still remains in the acquired J operation patterns $OP_1$ to $OP_J$ (YES in step ST15 in FIG. 5), the air conditioner control unit 15 operates the operation target air conditioner 1-k indicated by the operation pattern $OP_j$ in which the operation target air conditioner 1-k has not yet been operated at the set temperature $PT_k$ for a certain period of time (step ST12 in FIG. 5). The air conditioner control unit 15 operates the operation target air conditioner 1-k indicated by the operation pattern $OP_j$ Q times, for example.

When operating the operation target air conditioner 1-k at the set temperature $PT_k$, the air conditioner control unit 15 outputs the set temperature $PT_k$ of the air conditioner 1-k to each of the prediction model generating unit 13 and the operation pattern selecting unit 14. In addition, the air conditioner control unit 15 outputs a request to generate a room-temperature prediction model $RTM_j$ corresponding to the operation pattern $OP_j$ to the prediction model generating unit 13.

When operating the operation target air conditioner 1-k, the air conditioner control unit 15 outputs a data acquisition request to the temperature data acquiring unit 12.

When receiving the data acquisition request from the air conditioner control unit 15, the temperature data acquiring unit 12 acquires Q pieces of temperature data indicating the measurement temperature $MT_m$ of the temperature sensor 2-m (m = 1, ..., M) (step ST13 in FIG. 5).

The temperature data acquiring unit 12 outputs the acquired Q pieces of temperature data to the prediction model generating unit 13.

The prediction model generating unit 13 acquires, from the temperature data acquiring unit 12, Q pieces of temperature data when the operation target air conditioner 1-k indicated by the operation pattern $OP_j$ is operated at the set temperature $PT_k$.

The prediction model generating unit 13 acquires, from the air conditioner control unit 15, the set temperature $PT_k$ of the operation target air conditioner 1-k indicated by the operation pattern $OP_j$ and a request to generate the room-temperature prediction model $RTM_j$ corresponding to the operation pattern $OP_j$.

When acquiring the request to generate the room-temperature prediction model $RTM_j$, the prediction model generating unit 13 prepares the above-described Q data sets from the Q pieces of temperature data and the set temperature $PT_k$.

The prediction model generating unit 13 sequentially provides the data sets to the room-temperature prediction model $RTM_j$, and repeatedly performs training to change the internal parameter of the room-temperature prediction model $RTM_j$ in such a way that a prediction temperature $FT_j$ output from the room-temperature prediction model $RTM_j$ approaches the measurement temperature $MT_m$ indicated by the temperature data.

The prediction model generating unit 13 may not provide all the data sets to the room-temperature prediction model $RTM_j$ when the prediction accuracy of the room-temperature prediction model $RTM_j$ reaches or is beyond the threshold before providing the Q data sets to the room-temperature prediction model $RTM_j$.

The prediction model generating unit 13 continues the machine learning of the room-temperature prediction model $RTM_j$ by repeatedly providing the data sets to the room-temperature prediction model $RTM_j$, to thereby generate the room-temperature prediction model $RTM_j$ having the prediction accuracy equal to or higher than the threshold (step ST14 in FIG. 5).

The prediction model generating unit 13 outputs the room-temperature prediction model $RTM_j$ having the prediction accuracy equal to or higher than the threshold to the operation pattern selecting unit 14.

If there remains no operation pattern $OP_j$ in which the operation target air conditioner 1-k is not operated among the J operation patterns $OP_j$ (NO in step ST15 in FIG. 5), the operation pattern selecting unit 14 selects one room-temperature prediction model as the room-temperature prediction model $RTM_{j,N-3}$ from among the J room-temperature prediction models $RTM_1$ to $RTM_J$ having prediction accuracy equal to or higher than the threshold.

For example, the operation pattern selecting unit 14 selects one or more room-temperature prediction models $RTM_j$ in which the prediction temperature $FT_j$ is equal to or lower than the temperature upper limit value $T_{max}$ from among the J room-temperature prediction models $RTM_1$ to $RTM_J$ having prediction accuracy equal to or higher than the threshold.

Then, the operation pattern selecting unit 14 selects the room-temperature prediction model $RTM_j$ having the highest prediction temperature $FT_j$ as the room-temperature prediction model $RTM_{j,N-3}$ from among the one or more room-temperature prediction models $RTM_j$ having a prediction temperature $FT_j$ equal to or lower than the temperature upper limit value $T_{max}$.

The operation pattern selecting unit 14 determines the operation pattern $OP_j$ corresponding to the selected room-temperature prediction model $RTM_j$ as a candidate $OP_{SEL,N-3}$ for the operation pattern (step ST16 in FIG. 5).

Next, if the operation patterns $OP_1$ to $OP_G$ excluding the J operation patterns $OP_1$ to $OP_J$ include the operation pattern $OP_j$ in which the number of the operation target air conditioners 1-k is one less than the number of the operation target air conditioners 1-k indicated by the J operation patterns $OP_j$ which have been already acquired (YES in step ST17 in FIG. 5), the air conditioner control unit 15 acquires the operation pattern $OP_j$ in which the number of the operation target air conditioners 1-k is one less (step ST18 in FIG. 5). For example, if the number of the operation target air conditioners 1-k one less than the largest number is (N-4), and there are J' operation patterns $OP_j$ having (N-4) operation target air conditioners 1-k, the air conditioner control unit 15 acquires J' operation patterns $OP_1$ to $OP_{J'}$. J' ≤ G - J is established.

The processes of steps ST12 to ST15 are also repeated for the operation pattern $OP_j$ in which the number of the operation target air conditioners 1-k is (N -4).

If there are one or more room-temperature prediction models $RTM_j$ having prediction accuracy equal to or higher than the threshold, the operation pattern selecting unit 14 selects the room-temperature prediction model $RTM_j$ having the highest prediction temperature $FT_j$ as the room-temperature prediction model $RTM_{j,N-4}$ from among the one or more room-temperature prediction models $RTM_j$.

The operation pattern selecting unit 14 determines the operation pattern $OP_j$ corresponding to the selected room-temperature prediction model $RTM_j$ as a candidate $OP_{SEL,N-4}$ for the operation pattern (step ST16 in FIG. 5).

Afterwards, if the operation patterns $OP_1$ to $OP_G$ excluding the J operation patterns $OP_1$ to $OP_J$ and J' operation patterns $OP_1$ to $OP_J$ include the operation pattern $OP_j$ in which the number of the operation target air conditioners 1-k is one less than the number of the operation target air conditioners 1-k indicated by the J' operation patterns $OP_j$ which have been already acquired, a candidate for the operation pattern is further determined by a manner similar to the manner described above. Then, a candidate $OP_{SEL,N-5}$ for one operation pattern is selected.

If there is no operation pattern $OP_j$ in which the number of the operation target air conditioners 1-k is one less (NO in step ST17 in FIG. 5), the operation pattern selecting unit 14 selects one operation pattern $OP_{SEL}$ from among one or more operation pattern candidates (step ST19 in FIG. 5).

That is, the operation pattern selecting unit 14 selects a candidate for the operation pattern in which the number of the operation target air conditioners 1-k is the smallest from among the one or more operation pattern candidates as one operation pattern $OP_{SEL}$.

For example, when the candidates for the operation pattern are $OP_{SEL,N-3}$, $OP_{SEL,N-4}$, and $OP_{SEL,N-5}$, the operation pattern selecting unit 14 selects the candidate $OP_{SEL,N-5}$ for the operation pattern as the operation pattern $OP_{SEL}$.

Second Embodiment

The second embodiment describes an air conditioning control device 3 including a control amount changing unit 16 that changes a control amount of an operation target air conditioner 1-k indicated by an operation pattern selected by an operation pattern selecting unit 14.

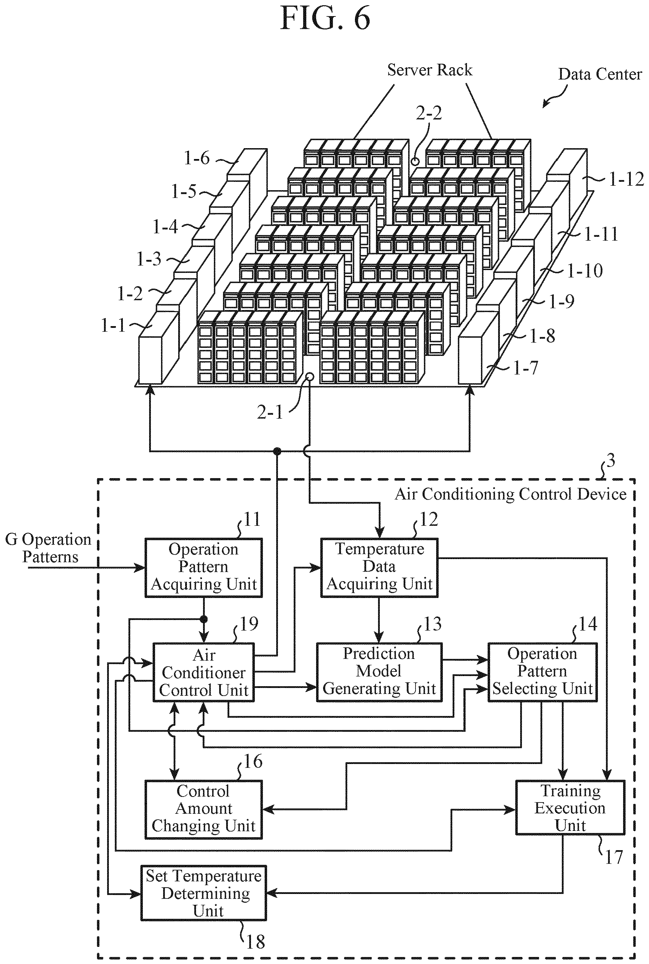

FIG. 6 is a configuration diagram illustrating an air conditioning system including the air conditioning control device 3 according to the second embodiment. In FIG. 6, elements same as or corresponding to the elements in FIG. 1 are identified by the same reference numerals, and thus, the description thereof will be omitted.

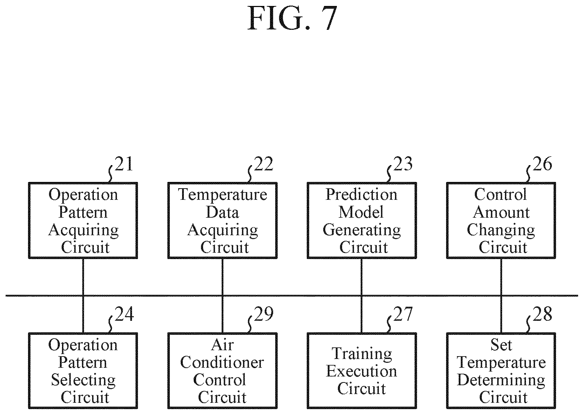

FIG. 7 is a hardware configuration diagram illustrating hardware of the air conditioning control device 3 according to the second embodiment. In FIG. 7, elements same as or corresponding to the elements in FIG. 2 are identified by the same reference numerals, and thus, the description thereof will be omitted.

The air conditioning control device 3 illustrated in FIG. 6 includes an operation pattern acquiring unit 11, a temperature data acquiring unit 12, a prediction model generating unit 13, the operation pattern selecting unit 14, the control amount changing unit 16, a training execution unit 17, a set temperature determining unit 18, and an air conditioner control unit 19.

The control amount changing unit 16 is implemented by, for example, a control amount changing circuit 26 illustrated in FIG. 7.

The control amount changing unit 16 changes a control amount of the operation target air conditioner 1-k indicated by an operation pattern $OP_{SEL}$ selected by the operation pattern selecting unit 14.

In the air conditioning control device 3 illustrated in FIG. 6, the control amount changing unit 16 changes the set temperature $PT_k$ of the air conditioner 1-k as the control amount of the air conditioner 1-k. However, this is merely an example, and the control amount changing unit 16 may change, as the control amount of the air conditioner 1-k, the air volume of the air conditioner 1-k or the frequency of an operating voltage of a compressor connected to the air conditioner 1-k.

The training execution unit 17 is implemented by, for example, a training execution circuit 27 illustrated in FIG. 7.

The training execution unit 17 acquires the temperature data acquired by the temperature data acquiring unit 12 when the operation target air conditioner 1-k indicated by the operation pattern $OP_{SEL}$ selected by the operation pattern selecting unit 14 is operating, and the set temperature $PT_k$ that is the control amount changed by the control amount changing unit 16.

The training execution unit 17 provides the acquired temperature data and the changed set temperature $PT_k$ to the room-temperature prediction model $RTM_g$ corresponding to the operation pattern $OP_{SEL}$ selected by the operation pattern selecting unit 14, and trains the room-temperature prediction model $RTM_g$ to learn the temperature measured by the temperature sensor 2-m when the operation target air conditioner 1-k indicated by the operation pattern $OP_{SEL}$ is operating.

The set temperature determining unit 18 is implemented by, for example, a set temperature determining circuit 28 illustrated in FIG. 7.

The set temperature determining unit 18 provides, as a tentatively set temperature $PT_k$ of the air conditioner 1-k, any one of a plurality of temperatures included in a settable temperature range of the air conditioner 1-k to the room-temperature prediction model $RTM_g$ that has been trained by the training execution unit 17, and acquires an indoor prediction temperature $FT_g$ from the trained room-temperature prediction model $RTM_g$.

The set temperature determining unit 18 determines the set temperature $PT_k$ of the air conditioner 1-k on the basis of the prediction temperature $FT_g$ and the temperature upper limit value $T_{max}$.

The air conditioner control unit 19 is implemented by, for example, an air conditioner control circuit 29 illustrated in FIG. 7.

The air conditioner control unit 19 operates the operation target air conditioner 1-k indicated by the operation pattern $OP_{SEL}$ selected by the operation pattern selecting unit 14 at the set temperature $PT_k$ determined by the set temperature determining unit 18.

FIG. 6 illustrates an example in which each of the operation pattern acquiring unit 11, the temperature data acquiring unit 12, the prediction model generating unit 13, the operation pattern selecting unit 14, the control amount changing unit 16, the training execution unit 17, the set temperature determining unit 18, and the air conditioner control unit 19, which are components of the air conditioning control device 3, is implemented by dedicated hardware as illustrated in FIG. 7. That is, it is assumed that the air conditioning control device 3 is implemented by the operation pattern acquiring circuit 21, the temperature data acquiring circuit 22, the prediction model generating circuit 23, the operation pattern selecting circuit 24, the control amount changing circuit 26, the training execution circuit 27, the set temperature determining circuit 28, and the air conditioner control circuit 29.

Here, each of the operation pattern acquiring circuit 21, the temperature data acquiring circuit 22, the prediction model generating circuit 23, the operation pattern selecting circuit 24, the control amount changing circuit 26, the training execution circuit 27, the set temperature determining circuit 28, and the air conditioner control circuit 29 is, for example, a single circuit, a composite circuit, a programmed processor, a parallel programmed processor, an ASIC, a FPGA, or a combination of some of these circuits.

The components of the air conditioning control device 3 are not limited to be implemented by dedicated hardware, and the air conditioning control device 3 may be implemented by software, firmware, or a combination of software and firmware.

In a case where the air conditioning control device 3 is implemented by software, firmware, or the like, a program for causing a computer to execute the processing procedures performed in the operation pattern acquiring unit 11, the temperature data acquiring unit 12, the prediction model generating unit 13, the operation pattern selecting unit 14, the control amount changing unit 16, the training execution unit 17, the set temperature determining unit 18, and the air conditioner control unit 19 is stored in the memory 31 illustrated in FIG. 3. Then, the processor 32 illustrated in FIG. 3 executes the program stored in the memory 31.

Further, FIG. 7 shows an example in which each of the components of the air conditioning control device 3 is implemented by dedicated hardware, and FIG. 3 shows an example in which the air conditioning control device 3 is implemented by software, firmware, or the like. However, this is merely an example, and some components in the air conditioning control device 3 may be implemented by dedicated hardware, and the remaining components may be implemented by software, firmware, or the like.

Next, the operation of the air conditioning system illustrated in FIG. 6 will be described.

The air conditioning system is similar to the air conditioning system illustrated in FIG. 1 except for the control amount changing unit 16, the training execution unit 17, the set temperature determining unit 18, and the air conditioner control unit 19. Here, operations of the control amount changing unit 16, the training execution unit 17, the set temperature determining unit 18, and the air conditioner control unit 19 will be described.

The control amount changing unit 16 acquires one selected operation pattern $OP_{SEL}$ from the operation pattern selecting unit 14, and acquires the set temperature $PT_k$ of the air conditioner 1-k as the control amount of the operation target air conditioner 1-k indicated by the operation pattern $OP_{SEL}$ from the air conditioner control unit 19.

The control amount changing unit 16 changes the set temperature $PT_k$ of the operation target air conditioner 1-k indicated by the operation pattern $OP_{SEL}$.

For example, the control amount changing unit 16 changes the set temperature $PT_k$ of the air conditioner 1-k by a method called active learning in order to train the room-temperature prediction model $RTM_g$ corresponding to the operation pattern $OP_{SEL}$ to efficiently learn the measurement temperature $MT_m$. In the process of changing the set temperature $PT_k$ by a method called active learning, a temperature farthest from the current set temperature in the settable temperature range of the air conditioner 1-k is determined as the next set temperature, and a temperature farthest from the set temperature that has been determined is further determined as the next set temperature.

An example of changing the set temperature $PT_k$ by a method called active learning will be specifically described below.

The control amount changing unit 16 calculates a temperature difference $\Delta PT_k$ between each of temperatures other than the set temperature $PT_k$ that is currently set and the set temperature $PT_k$ that is currently set among the plurality of temperatures included in the settable temperature range of the air conditioner 1-k.

For example, suppose that a plurality of temperatures included in the settable temperature range is 19 degrees, 20 degrees, 21 degrees, 22 degrees, and 23 degrees, and the currently set temperature $PT_k$ is 19 degrees.

In this case, the control amount changing unit 16 calculates 1 (= 20 - 19) degree, 2 (= 21 - 19) degrees, 3 (= 22 - 19) degrees, and 4 (= 23 - 19) degrees as the temperature differences $\Delta PT_k$.

The control amount changing unit 16 selects the changed set temperature $PT_k$ from the plurality of temperatures included in the temperature range on the basis of the calculated temperature differences $\Delta PT_k$.

That is, the control amount changing unit 16 specifies the temperature difference $\Delta PT_k$ (= 4 degrees) having the maximum absolute value among the plurality of calculated temperature differences $\Delta PT_k$, and determines 23 degrees, which is the temperature corresponding to the temperature difference $\Delta PT_k$ (= 4 degrees) having the maximum absolute value, as the set temperature $PT_k$ (= 23 degrees) after the first change.

Then, the control amount changing unit 16 calculates a temperature difference $\Delta PT_k$ between each of temperatures that have not yet been set as the set temperature $PT_k$ among the plurality of temperatures included in the settable temperature range of the air conditioner 1-k and the set temperature $PT_k$ (= 23 degrees) after the first change.

The control amount changing unit 16 calculates -3 (= 20 - 23) degrees, -2 (= 21 - 23) degrees, and -1 (= 22 - 23) degrees as the temperature differences $\Delta PT_k$.

The control amount changing unit 16 specifies the temperature difference $\Delta PT_k$ (= -3 degrees) having the maximum absolute value among the plurality of calculated temperature differences $\Delta PT_k$, and determines 20 degrees, which is the temperature corresponding to the temperature difference $\Delta PT_k$ (= -3 degrees) having the maximum absolute value, as the set temperature $PT_k$ (= 20 degrees) after the second change.

Then, the control amount changing unit 16 calculates a temperature difference $\Delta PT_k$ between each of temperatures that have not yet been set as the set temperature $PT_k$ among the plurality of temperatures included in the settable temperature range of the air conditioner 1-k and the set temperature $PT_k$ (= 20 degrees) after the second change.

The control amount changing unit 16 calculates 1 (= 21 - 20) degree and 2 (= 22 - 20) degrees as the temperature differences $\Delta PT_k$.

The control amount changing unit 16 specifies the temperature difference $\Delta PT_k$ (= 2 degrees) having the maximum absolute value among the plurality of calculated temperature differences $\Delta PT_k$, and determines 22 degrees, which is the temperature corresponding to the temperature difference $\Delta PT_k$ (= 2 degrees) having the maximum absolute value, as the set temperature $PT_k$ (= 22 degrees) after the third change.

The control amount changing unit 16 determines 21 degrees, which is a temperature not yet set as the set temperature $PT_k$ among the plurality of temperatures included in the temperature range, as the set temperature $PT_k$ (= 21 degrees) after the fourth change.

Therefore, the set temperature $PT_k$ of the air conditioner 1-k is changed as follows.

19 degrees $\rightarrow$ 23 degrees $\rightarrow$ 20 degrees $\rightarrow$ 22 degrees $\rightarrow$ 21 degrees

The control amount changing unit 16 outputs set temperature changing information indicating the detail of the change of the set temperature $PT_k$ of the air conditioner 1-k to the air conditioner control unit 19.

The set temperature changing information indicates that the set temperature $PT_k$ is changed in the order of 23 degrees, 20 degrees, 22 degrees, and 21 degrees from 19 degrees.

The air conditioner control unit 19 acquires the set temperature changing information from the control amount changing unit 16, and acquires the operation pattern $OP_{SEL}$ from the operation pattern selecting unit 14.

In order to improve the prediction accuracy of the room-temperature prediction model $RTM_g$ corresponding to the operation pattern $OP_{SEL}$, the air conditioner control unit 19 operates the operation target air conditioner 1-k indicated by the operation pattern $OP_{SEL}$ by switching the set temperature $PT_k$ of the air conditioner 1-k in the order indicated by the set temperature changing information.

That is, the air conditioner control unit 19 operates the operation target air conditioner 1-k at the set temperature $PT_k$ (= 23 degrees) for a certain period of time, and then operates the air conditioner 1-k at the set temperature $PT_k$ (= 20 degrees) for a certain period of time. Thereafter, the air conditioner control unit 19 operates the operation target air conditioner 1-k at the set temperature $PT_k$ (= 22 degrees) for a certain period of time, and then operates the air conditioner 1-k at the set temperature $PT_k$ (= 21 degrees) for a certain period of time.

Although described in detail later, when the prediction accuracy of the room-temperature prediction model $RTM_g$ corresponding to the operation pattern $OP_{SEL}$ reaches high accuracy $A_{ns}$ when the operation target air conditioner 1-k is operated at, for example, the set temperature $PT_k$ (= 20 degrees) for a certain period of time, the air conditioner control unit 19 does not operate the air conditioner 1-k at the set temperature $PT_k$ (= 22 and 21 degrees). The high accuracy $A_{ns}$ means that the prediction accuracy of the room-temperature prediction model $RTM_g$ is practically satisfactory, and may be, for example, 0.5 degrees or 0.6 degrees.

When operating the operation target air conditioner 1-k at the set temperature $PT_k$, the air conditioner control unit 19 outputs the set temperature $PT_k$ (= 23 degrees) after the first change to the training execution unit 17.

When operating the operation target air conditioner 1-k at the set temperature $PT_k$ (= 23 degrees) after the first change, the air conditioner control unit 19 outputs a data acquisition request to the temperature data acquiring unit 12.

The training execution unit 17 acquires one selected operation pattern $OP_{SEL}$ from the operation pattern selecting unit 14.

The training execution unit 17 acquires the set temperature $PT_k$ (= 23 degrees) after the first change from the air conditioner control unit 19.

The training execution unit 17 acquires the temperature data acquired by the temperature data acquiring unit 12 when the operation target air conditioner 1-k indicated by the operation pattern $OP_{SEL}$ is operating at the set temperature $PT_k$ (= 23 degrees) after the first change.

The training execution unit 17 provides the acquired temperature data and set temperature $PT_k$ (= 23 degrees) to the room-temperature prediction model $RTM_g$ corresponding to the operation pattern $OP_{SEL}$ to thereby train the room-temperature prediction model $RTM_g$ to learn the set temperature $PT_k$ which is the temperature measured by the temperature sensor 2-m when the operation target air conditioner 1-k indicated by the operation pattern $OP_{SEL}$ is operating. As a result, the prediction accuracy of the room-temperature prediction model $RTM_g$ is improved by learning. Thus, the accuracy of the prediction temperature $FT_g$ output from the prediction model $RTM_g$ is improved.

The training execution unit 17 outputs the prediction accuracy of the room-temperature prediction model $RTM_g$ which has been trained to the air conditioner control unit 19.

When the prediction accuracy of the room-temperature prediction model $RTM_g$ output from the training execution unit 17 is less than the high accuracy $A_{ns}$, the air conditioner control unit 19 operates the operation target air conditioner 1-k at the set temperature $PT_k$ (= 20 degrees) after the second change.

When operating the operation target air conditioner 1-k at the set temperature $PT_k$ (= 20 degrees) after the second change, the air conditioner control unit 19 outputs the set temperature $PT_k$ (= 20 degrees) after the second change to the training execution unit 17.

When operating the operation target air conditioner 1-k, the air conditioner control unit 19 outputs a data acquisition request to the temperature data acquiring unit 12.

When the prediction accuracy of the room-temperature prediction model $RTM_g$ output from the training execution unit 17 is equal to or higher than the high accuracy $A_{ns}$, the air conditioner control unit 19 does not thereafter operate the air conditioner 1-k for enhancing the prediction accuracy of the room-temperature prediction model $RTM_g$.

The training execution unit 17 acquires the set temperature $PT_k$ (= 20 degrees) after the second change from the air conditioner control unit 19.

The training execution unit 17 acquires the temperature data acquired by the temperature data acquiring unit 12 when the operation target air conditioner 1-k indicated by the operation pattern $OP_{SEL}$ is operating at the set temperature $PT_k$ (= 20 degrees).

The training execution unit 17 provides the acquired temperature data and set temperature $PT_k$ (= 20 degrees) to the room-temperature prediction model $RTM_g$ corresponding to the operation pattern $OP_{SEL}$ to thereby train the room-temperature prediction model $RTM_g$ to learn the set temperature $PT_k$ which is the temperature measured by the temperature sensor 2-m when the operation target air conditioner 1-k indicated by the operation pattern $OP_{SEL}$ is operating.

The training execution unit 17 outputs the prediction accuracy of the room-temperature prediction model $RTM_g$ which has been trained to the air conditioner control unit 19.

When the prediction accuracy of the room-temperature prediction model $RTM_g$ output from the training execution unit 17 is less than the high accuracy $A_{ns}$, the air conditioner control unit 19 operates the operation target air conditioner 1-k at the set temperature $PT_k$ (= 22 degrees) after the third change.

When operating the operation target air conditioner 1-k at the set temperature $PT_k$ (= 22 degrees) after the third change, the air conditioner control unit 19 outputs the set temperature $PT_k$ (= 22 degrees) after the third change to the training execution unit 17.

When operating the operation target air conditioner 1-k, the air conditioner control unit 19 outputs a data acquisition request to the temperature data acquiring unit 12.

When the prediction accuracy of the room-temperature prediction model $RTM_g$ output from the training execution unit 17 is equal to or higher than the high accuracy $A_{ns}$, the air conditioner control unit 19 does not thereafter operate the air conditioner 1-k for enhancing the prediction accuracy of the room-temperature prediction model $RTM_g$.

The training execution unit 17 acquires the set temperature $PT_k$ (= 22 degrees) after the third change from the air conditioner control unit 19.

The training execution unit 17 acquires the temperature data acquired by the temperature data acquiring unit 12 when the operation target air conditioner 1-k indicated by the operation pattern $OP_{SEL}$ is operating at the set temperature $PT_k$ (= 22 degrees).

The training execution unit 17 provides the acquired temperature data and set temperature $PT_k$ (= 22 degrees) to the room-temperature prediction model $RTM_g$ corresponding to the operation pattern $OP_{SEL}$ to thereby train the room-temperature prediction model $RTM_g$ to learn the set temperature $PT_k$ which is the temperature measured by the temperature sensor 2-m when the operation target air conditioner 1-k indicated by the operation pattern $OP_{SEL}$ is operating.

The training execution unit 17 outputs the prediction accuracy of the room-temperature prediction model $RTM_g$ which has been trained to the air conditioner control unit 19.

When the prediction accuracy of the room-temperature prediction model $RTM_g$ output from the training execution unit 17 is less than the high accuracy $A_{ns}$, the air conditioner control unit 19 operates the operation target air conditioner 1-k at the set temperature $PT_k$ (= 21 degrees) after the fourth change.

When operating the operation target air conditioner 1-k at the set temperature $PT_k$ (= 21 degrees) after the fourth change, the air conditioner control unit 19 outputs the set temperature $PT_k$ (= 21 degrees) after the fourth change to the training execution unit 17.

When operating the operation target air conditioner 1-k, the air conditioner control unit 19 outputs a data acquisition request to the temperature data acquiring unit 12.

When the prediction accuracy of the room-temperature prediction model $RTM_g$ output from the training execution unit 17 is equal to or higher than the high accuracy $A_{ns}$, the air conditioner control unit 19 does not thereafter operate the air conditioner 1-k for enhancing the prediction accuracy of the room-temperature prediction model $RTM_g$.

The training execution unit 17 acquires the set temperature $PT_k$ (= 21 degrees) after the fourth change from the air conditioner control unit 19.

The training execution unit 17 acquires the temperature data acquired by the temperature data acquiring unit 12 when the operation target air conditioner 1-k indicated by the operation pattern $OP_{SEL}$ is operating at the set temperature $PT_k$ (= 21 degrees).

The training execution unit 17 provides the acquired temperature data and set temperature $PT_k$ (= 21 degrees) to the room-temperature prediction model $RTM_g$ corresponding to the operation pattern $OP_{SEL}$ to thereby train the room-temperature prediction model $RTM_g$ to learn the set temperature $PT_k$ which is the temperature measured by the temperature sensor 2-m when the operation target air conditioner 1-k indicated by the operation pattern $OP_{SEL}$ is operating.

The room-temperature prediction model $RTM_g$ is efficiently trained by the training execution unit 17 by changing the set temperature $PT_k$ of the air conditioner 1-k by a method called active learning. Therefore, it is presumed that the prediction accuracy of the room-temperature prediction model $RTM_g$ is equal to or higher than the high accuracy $A_{ns}$ before all of the plurality of temperatures included in the settable temperature range of the air conditioner 1-k are set as the set temperature $PT_k$. Accordingly, the accuracy of the room-temperature prediction model $RTM_g$ is improved more quickly by changing the set temperature $PT_k$ with a method called active learning than by, for example, setting the temperatures included in the settable temperature range as the set temperature $PT_k$ in the order from a lower to a higher temperature. Therefore, in a case where the set temperature $PT_k$ is changed by a method called active learning, the time required for training the room-temperature prediction model $RTM_g$ is shortened as compared with the case where the temperatures are set as the set temperature $PT_k$ in the order from a lower to a higher temperature.

The set temperature determining unit 18 determines each of the plurality of temperatures included in the settable temperature range of the air conditioner 1-k as a tentatively set temperature $PT_k'$ of the air conditioner 1-k.

The set temperature determining unit 18 provides each of the tentatively set temperatures $PT_k'$ to the room-temperature prediction model $RTM_g$ that has been trained by the training execution unit 17, and acquires the prediction temperature $FT_g$ from each of the trained room-temperature prediction models $RTM_g$.

The set temperature determining unit 18 specifies a prediction temperature $FT_g$ equal to or lower than the temperature upper limit value $T_{max}$ among the plurality of prediction temperatures $FT_g$.

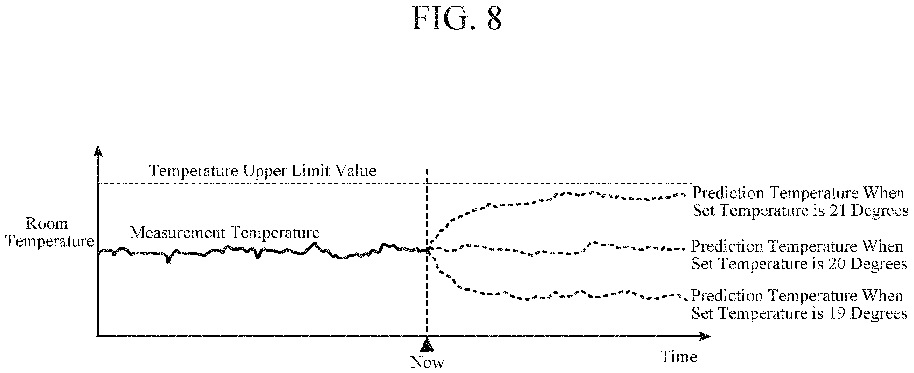

The set temperature determining unit 18 determines the highest temperature among the prediction temperatures $FT_g$ equal to or lower than the temperature upper limit value $T_{max}$ as the set temperature $PT_k$ of the air conditioner 1-k as illustrated in FIG. 8.

FIG. 8 is an explanatory diagram illustrating candidates for the set temperature $PT_k$ determined by the set temperature determining unit 18.

In FIG. 8, the horizontal axis indicates a time, and "Now" indicates a current time. The vertical axis represents the indoor temperature.

In the example of FIG. 8, the prediction temperature $FT_g$ is equal to or lower than the temperature upper limit value $T_{max}$ when the tentatively set temperature $PT_k'$ is 19 degrees, 20 degrees, and 21 degrees.

The prediction temperature $FT_g$ when the tentatively set temperature $PT_k'$ is 21 degrees is the highest temperature among the prediction temperatures $FT_g$ when the tentatively set temperature $PT_k'$ is 19 degrees, 20 degrees, and 21 degrees, and thus, the set temperature determining unit 18 determines 21 degrees as the set temperature $PT_k$ of the air conditioner 1-k.

The set temperature determining unit 18 outputs the determined set temperature $PT_k$ of the air conditioner 1-k to the air conditioner control unit 19.

The air conditioner control unit 19 operates the operation target air conditioner 1-k indicated by the operation pattern $OP_{SEL}$ at the set temperature $PT_k$ determined by the set temperature determining unit 18.

In the second embodiment described above, the air conditioning control device 3 includes: the control amount changing unit 16 to change the control amount of the operation target air conditioner 1-k indicated by the operation pattern selected by the operation pattern selecting unit 14; and the training execution unit 17 to provide, as training data, the control amount that has been changed by the control amount changing unit 16 and the temperature data acquired by the temperature data acquiring unit 12 when the operation target air conditioner 1-k indicated by the operation pattern selected by the operation pattern selecting unit 14 is in operation to the room-temperature prediction model corresponding to the operation pattern selected by the operation pattern selecting unit 14, and train the room-temperature prediction model to learn the temperature measured by the temperature sensor 2-m when the operation target air conditioner is in operation. Accordingly, the air conditioning control device 3 can determine the air conditioner 1-k to be actually operated among the plurality of air conditioners 1-1 to 1-N without acquiring layout data, and further, can change the control amount of the operation target air conditioner 1-k.

In addition, in the second embodiment, the control amount of the operation target air conditioner 1-k is a set temperature of the air conditioner 1-k, and the air conditioning control device 3 includes the set temperature determining unit 18 to provide, to the room-temperature prediction model that has been trained by the training execution unit 17, any of a plurality of temperatures included in a settable temperature range of the air conditioner 1-k as a tentatively set temperature of the air conditioner 1-k to acquire a prediction temperature from the room-temperature prediction model that has been trained, and determine the set temperature of the air conditioner 1-k on the basis of the prediction temperature and the temperature upper limit value. With this configuration, the air conditioning control device 3 can determine the set temperature at which the power consumption can be reduced within a range in which the indoor temperature does not exceed the temperature upper limit value.

In the air conditioning control device 3 illustrated in FIG. 6, the control amount changing unit 16 changes the set temperature $PT_k$ of the air conditioner 1-k by a method called active learning.

The process of changing the set temperature $PT_k$ by a method called active learning is not limited to determine a temperature farthest from the current set temperature in the settable temperature range of the air conditioner 1-k as the next set temperature, and the control amount changing unit 16 may determine the next set temperature as follows.

The control amount changing unit 16 obtains an evaluation value indicating the accuracy of the room-temperature prediction model $RTM_g$ with respect to each set temperature $PT_k$ when each of the plurality of temperatures included in the settable temperature range of the air conditioner 1-k is set to the set temperature $PT_k$ using Bayesian optimization, for example. The evaluation value is larger as the accuracy of the room-temperature prediction model

$RTM_g$ with respect to the set temperature $PT_k$ is higher. Since the Bayesian optimization is a known technique, the detailed description thereof will be omitted. When, for example, evaluation values indicating the accuracy of the room-temperature prediction models $RTM_g$ with respect to two set temperatures $PT_k$ are known in a case where the Bayesian optimization is used, evaluation values indicating the accuracy of the room-temperature prediction models $RTM_g$ with respect to the remaining set temperatures $PT_k$ are obtained.

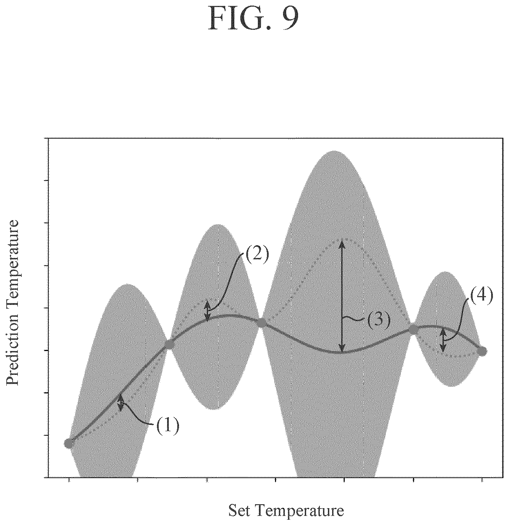

FIG. 9 is an explanatory diagram illustrating accuracy of the room-temperature prediction model $RTM_g$ with respect to the set temperature $PT_k$.

In FIG. 9, • indicates the set temperature $PT_k$ that has been set. A solid line indicates a prediction temperature $FT_g$ which is an output temperature of the room-temperature prediction model $RTM_g$ with respect to the set temperature $PT_k$, and a dotted line indicates a true value of the prediction temperature $FT_g$.

The interval between the solid line and the dotted line represents an evaluation value indicating the accuracy of the room-temperature prediction model $RTM_g$ with respect to the set temperature $PT_k$. The lengths of arrows (1) to (4) indicate the interval between the solid line and the dotted line. The narrower the interval between the solid line and the dotted line, the higher the evaluation value. In the example of FIG. 9, length of arrow (1) < length of arrow (2) < length of arrow (4) < length of arrow (3). In the drawing, the gray area indicates an area in which the reliability of the room-temperature prediction model $RTM_g$ is about 95%.

The control amount changing unit 16 compares evaluation values indicating the accuracy of the room-temperature prediction models $RTM_g$ with respect to temperatures that have not yet been set as the set temperature $PT_k$ among the plurality of temperatures included in the settable temperature range of the air conditioner 1-k.

If the temperatures that have not yet been set as the set temperature $PT_k$ are, for example, the temperatures corresponding to the arrows (1) to (4), the lengths of the arrows (1) to (4) are compared with each other.

The control amount changing unit 16 determines the temperature having the smallest evaluation value as the next set temperature $PT_k$, and further determines the temperature having the second smallest evaluation value as the set temperature $PT_k$ next to the immediately preceding set temperature $PT_k$ on the basis of the comparison result of the evaluation values. Thereafter, the control amount changing unit 16 determines the set temperatures $PT_k$ in ascending order of evaluation values.

In the example of FIG. 9, the control amount changing unit 16 first determines the temperature corresponding to the arrow (3) having the smallest evaluation value as the next set temperature $PT_k$, and determines the temperature corresponding to the arrow (4) having the second smallest evaluation value as the set temperature $PT_k$ next to the immediately preceding set temperature $PT_k$. The control amount changing unit 16 determines the temperature corresponding to the arrow (2) having the third smallest evaluation value as the set temperature $PT_k$ next to the immediately preceding set temperature $PT_k$, and in the end, determines the temperature corresponding to the arrow (1) having the largest evaluation value as the set temperature $PT_k$ next to the immediately preceding set temperature $PT_k$.

Even when the control amount changing unit 16 determines the next set temperature as described above, the room-temperature prediction model $RTM_g$ is effectively trained to learn the measurement temperature $MT_m$.

In the example of FIG. 9, the control amount changing unit 16 determines the set temperature $PT_k$ in order of the length of arrow. However, this is merely an example, and the control amount changing unit 16 may preferentially determine the temperature included in a large gray area as the set temperature $PT_k$.

In FIG. 9, the control amount changing unit 16 determines, for example, the temperature corresponding to the arrow (2) as the set temperature $PT_k$ before the temperature corresponding to the arrow (1). However, the control amount changing unit 16 may determine the temperature corresponding to the arrow (1) as the set temperature $PT_k$ before the temperature corresponding to the arrow (2) on the basis of the size of the gray area.

In the air conditioning control device 3 illustrated in FIG. 6, the training execution unit 17 trains the operation pattern $OP_{SEL}$ selected by the operation pattern selecting unit 14 to learn the temperature measured by the temperature sensor 2-m, and then, the air conditioner control unit 19 operates the operation target air conditioner 1-k indicated by the trained operation pattern $OP_{SEL}$ at the set temperature $PT_k$ determined by the set temperature determining unit 18. However, the operation pattern $OP_{SEL}$ selected by the operation pattern selecting unit 14 may be changed depending on a change in an operation mode or the like of an electronic device installed in a data center or the like. In such a case, the training execution unit 17 may train the changed operation pattern $OP_{SEL}$ to learn the temperature measured by the temperature sensor 2-m.

It is to be noted that, in the present disclosure, any embodiments can be freely combined to each other, or any component in the embodiments can be modified or omitted.

**INDUSTRIAL APPLICABILITY**

The air conditioning control device according to the present disclosure can be used for air-conditioning control of a server room or the like, for example.

**REFERENCE SIGNS LIST**

1-1 to 1-12: air conditioner, 2-1 to 2-2: temperature sensor, 3: air conditioning control device, 11: operation pattern acquiring unit, 12: temperature data acquiring unit, 13: prediction model generating unit, 14: operation pattern selecting unit, 15: air conditioner control unit, 16: control amount changing unit, 17: training execution unit, 18: set temperature determining unit, 19: air conditioner control unit, 21: operation pattern acquiring circuit, 22: temperature data acquiring circuit, 23: prediction model generating circuit, 24: operation pattern selecting circuit, 25: air conditioner control circuit, 26: control amount changing circuit, 27: training execution circuit, 28: set temperature determining circuit, 29: air conditioner control circuit, 31: memory, 32: processor

**Claims**

1.  An air conditioning control device comprising:

    an operation pattern acquiring unit to acquire a plurality of operation patterns each indicating at least one operation target air conditioner among a plurality of air conditioners installed in a room;
    a temperature data acquiring unit to acquire temperature data indicating a measurement temperature of a temperature sensor installed in the room when the at least one operation target air conditioner indicated by each of the plurality of operation patterns is in operation;
    a prediction model generating unit to generate, using a control amount of the at least one operation target air conditioner indicated by each of the plurality of operation patterns and the temperature data acquired by the temperature data acquiring unit when the at least one operation target air conditioner is in operation as training data, a room-temperature prediction model, which corresponds to each of the plurality of operation patterns, for predicting a temperature measured by the temperature sensor when the at least one operation target air conditioner indicated by each of the plurality of operation patterns is in operation; and
    an operation pattern selecting unit to acquire a prediction temperature from the room-temperature prediction model by providing the control amount of the at least one operation target air conditioner indicated by each of the plurality of operation patterns to the room-temperature prediction model generated by the prediction model generating unit, and selects one operation pattern from the plurality of operation patterns on a basis of the prediction temperature.

2.  The air conditioning control device according to claim 1, further comprising an air conditioner control unit to operate the at least one operation target air conditioner indicated by the operation pattern selected by the operation pattern selecting unit.

3.  The air conditioning control device according to claim 1, wherein
    the operation pattern selecting unit selects, with respect to each of the plurality of operation patterns acquired by the operation pattern acquiring unit, at least one operation pattern in which the prediction temperature obtained from the room-temperature prediction model corresponding to said each of the plurality of operation patterns is equal to or lower than a temperature upper limit value and prediction accuracy of the room-temperature prediction model corresponding to said each of the plurality of operation patterns is within a threshold, and selects, from the at least one operation pattern selected, the ne operation pattern in which the number of the at least one operation target air conditioner is relatively small.

4.  The air conditioning control device according to claim 1, further comprising:

    a control amount changing unit to change the control amount of the at least one operation target air conditioner indicated by the one operation pattern selected by the operation pattern selecting unit; and
    a training execution unit to train the room-temperature prediction model to learn the temperature measured by the temperature sensor when the at least one operation target air conditioner is in operation by providing, as training data, the control amount that has been changed by the control amount changing unit and the temperature data acquired by the temperature data acquiring unit when the at least one operation target air conditioner indicated by the one operation pattern selected by the operation pattern selecting unit is in operation to the room-temperature prediction model corresponding to the one operation pattern.

5.  The air conditioning control device according to claim 4, wherein

the control amount of the at least one operation target air conditioner is a set temperature of the at least one operation target air conditioner,

the control amount changing unit calculates temperature differences between a plurality of temperatures included in a settable temperature range of the at least one operation target air conditioner and a current set temperature that is currently set, and determines an order of setting the plurality of temperatures to the set temperature on a basis of the temperature differences that have been calculated, and

the training execution unit provides the plurality of temperatures to the room-temperature prediction model corresponding to the one operation pattern selected by the operation pattern selecting unit in time order from an earlier time to a later time and trains the room-temperature prediction model to learn the temperature measured by the temperature sensor when the at least one operation target air conditioner is in operation.

6. The air conditioning control device according to claim 4, wherein

the control amount of the at least one operation target air conditioner is a set temperature of the at least one operation target air conditioner, and

the air conditioning control device includes a set temperature determining unit to acquire a prediction temperature from the room-temperature prediction model that has been trained by providing, to the room-temperature prediction model that has been trained by the training execution unit, one of a plurality of temperatures included in a settable temperature range of the at least one operation target air conditioner as a tentatively set temperature of the at least one operation target air conditioner, and determines the set temperature of the at least one operation target air conditioner on a basis of the prediction temperature and a temperature upper limit value.

7. The air conditioning control device according to claim 6, further comprising an air conditioner control unit to operate the at least one operation target air conditioner indicated by the operation pattern selected by the operation pattern selecting unit at the set temperature determined by the set temperature determining unit.

8. An air conditioning control method comprising:

acquiring, by an operation pattern acquiring unit, a plurality of operation patterns each indicating at least one operation target air conditioner among a plurality of air conditioners installed in a room;

acquiring, by a temperature data acquiring unit, temperature data indicating a measurement temperature of a temperature sensor installed in the room when the at least one operation target air conditioner indicated by each of the plurality of operation patterns is in operation;

generating, by a prediction model generating unit, using a control amount of the at least one operation target air conditioner indicated by each of the plurality of operation patterns and the temperature data acquired by the temperature data acquiring unit when the at least one operation target air conditioner is in operation as training data, a room-temperature prediction model, which corresponds to each of the plurality of operation patterns, for predicting a temperature measured by the temperature sensor when the at least one operation target air conditioner indicated by each of the plurality of operation patterns is in operation; and

acquiring, by an operation pattern selecting unit, a prediction temperature from the room-temperature prediction model by providing the control amount of the at least one operation target air conditioner indicated by each of the plurality of operation patterns to the room-temperature prediction model generated by the prediction model generating unit, and selecting one operation pattern from the plurality of operation patterns on a basis of the prediction temperature.

# FIG. 1

Server Rack

Data Center

1-6
1-5
1-4
1-3
1-2
1-1

2-2

1-12
1-11
1-10
1-9
1-8
1-7

2-1

Air Conditioning Control Device

3

G Operation Patterns

Operation Pattern Acquiring Unit

11

Temperature Data Acquiring Unit

12

Air Conditioner Control Unit

15

Prediction Model Generating Unit

13

Operation Pattern Selecting Unit

14

# FIG. 2

| 21 | 22 | 23 |
|---|---|---|
| Operation Pattern Acquiring Circuit | Temperature Data Acquiring Circuit | Prediction Model Generating Circuit |

| 24 | 25 |
|---|---|
| Operation Pattern Selecting Circuit | Air Conditioner Control Circuit |

# FIG. 3

| 31 | 32 |
|---|---|
| Memory | Processor |

# FIG. 4

```
        ┌──────────┐
        │  START   │
        └──────────┘
             │
             ▼
   ┌─────────────────────────┐
   │ Acquire G Operation Patterns by │ ─ ST1
   │ Operation Pattern Acquiring Unit │
   └─────────────────────────┘
             │
             ▼
   ┌─────────────────────────┐
   │   Acquire Temperature Data by   │ ─ ST2
   │ Temperature Data Acquiring Unit │
   └─────────────────────────┘
             │
             ▼
   ┌─────────────────────────┐
   │  Generate G Room-temperature    │
   │      Prediction Models by       │ ─ ST3
   │ Prediction Model Generating Unit│
   └─────────────────────────┘
             │
             ▼
   ┌─────────────────────────┐
   │ Select One Operation Pattern from │
   │      G Operation Patterns by      │ ─ ST4
   │  Operation Pattern Selecting Unit │
   └─────────────────────────┘
             │
             ▼
   ┌─────────────────────────┐
   │            Operate              │
   │ Operation Target Air Conditioner│
   │  Indicated by Selected Operation│ ─ ST5
   │  Pattern at Set Temperature by  │
   │    Air Conditioner Control Unit │
   └─────────────────────────┘
             │
             ▼
        ┌──────────┐
        │   END    │
        └──────────┘
```

## FIG. 5

```
START
```

↓

Acquire, by
Air Conditioner Control Unit,
J Operation Patterns in which
the Number of Operation
Target Air Conditioners is
the Largest from
G Operation Patterns  ~ST11

↓

Operate Operation Target Air
Conditioners by Air Conditioner
Control Unit  ~ST12

↓

Acquire Temperature Data by
Temperature Data Acquiring Unit  ~ST13

↓

Generate Room-temperature
Prediction Model by
Prediction Model Generating Unit  ~ST14

↓

ST15

Does
Operation Pattern in which
Operation Target Air Conditioner
Has not been Operated
Still Remain?

YES → (back to ST12)

NO ↓

Determine Candidate for
Operation Pattern by
Operation Pattern Selecting Unit  ~ST16

↓

ST17

Is there
Operation Pattern in which
the Number of Operation
Target Air Conditioners is
One Less?

YES ↓

Acquire Operation Pattern in
which the Number is One Less by
Air Conditioner Control Unit  ~ST18

NO ↓

ST19

Select One Operation Pattern from
One or More Operation Pattern Candidates by
Air Conditioner Control Unit

↓

```
END
```

23

# FIG. 6

# FIG. 7

| Operation Pattern Acquiring Circuit /21 | Temperature Data Acquiring Circuit /22 | Prediction Model Generating Circuit /23 | Control Amount Changing Circuit /26 |
|---|---|---|---|

| Operation Pattern Selecting Circuit /24 | Air Conditioner Control Circuit /29 | Training Execution Circuit /27 | Set Temperature Determining Circuit /28 |
|---|---|---|---|

# FIG. 8

Temperature Upper Limit Value

Room Temperature

Measurement Temperature

Prediction Temperature When Set Temperature is 21 Degrees

Prediction Temperature When Set Temperature is 20 Degrees

Prediction Temperature When Set Temperature is 19 Degrees

Now

Time

EP 4 350 240 A1

# FIG. 9

## INTERNATIONAL SEARCH REPORT

| International application No. |
|---|
| **PCT/JP2022/021873** |

**A. CLASSIFICATION OF SUBJECT MATTER**

*F24F 11/65*(2018.01)i; *F24F 110/10*(2018.01)n
FI: F24F11/65; F24F110:10

According to International Patent Classification (IPC) or to both national classification and IPC

**B. FIELDS SEARCHED**

Minimum documentation searched (classification system followed by classification symbols)

F24F11/65; F24F110/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2019-132457 A (FUJITSU LTD.) 08 August 2019 (2019-08-08) paragraphs [0012]-[0252], fig. 1-18 | 1-2, 4, 8 |
| Y | | 3, 5-7 |
| Y | WO 2020/065807 A1 (NEC CORP.) 02 April 2020 (2020-04-02) paragraph [0118] | 3 |
| Y | JP 2020-29970 A (NTT FACILITIES INC.) 27 February 2020 (2020-02-27) paragraphs [0028], [0066], [0067] | 5-7 |
| A | JP 2020-95616 A (TOSHIBA CORP.) 18 June 2020 (2020-06-18) entire text, all drawings | 1-8 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 August 2022** | **16 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/021873**

| Patent document cited in search report | | | Publication date (day/month/year) | Patent family member(s) | Publication date (day/month/year) |
|---|---|---|---|---|---|
| JP | 2019-132457 | A | 08 August 2019 | (Family: none) | |
| WO | 2020/065807 | A1 | 02 April 2020 | (Family: none) | |
| JP | 2020-29970 | A | 27 February 2020 | (Family: none) | |
| JP | 2020-95616 | A | 18 June 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018005646 A